Europäisches Patentamt

European Patent Office

Office européen des brevets

(19)

(11) Publication number: **0 350 310**
**A2**

(12) # EUROPEAN PATENT APPLICATION

(21) Application number: **89306882.5**

(22) Date of filing: **06.07.89**

(51) Int. Cl.⁵: **G 03 G 15/28**
**G 03 B 27/52, G 03 F 7/00**

(30) Priority: **06.07.88 JP 168548/88**
**12.07.88 JP 175935/88**
**12.07.88 JP 175939/88**
**12.07.88 JP 175937/88**

(43) Date of publication of application:
**10.01.90 Bulletin 90/02**

(84) Designated Contracting States: **DE FR GB**

(71) Applicant: **BROTHER KOGYO KABUSHIKI KAISHA**
**35, 9-chome, Horita-dori Mizuho-ku**
**Nagoya-shi, Aichi-ken (JP)**

(72) Inventor: **Suzuki, Tsuyoshi 401 Fujigaoka House**
**No.13, Asahigaoka Meito-ku**
**Nagoya-shi Aichi-ken (JP)**

**Takemoto, Takatoshi**
**1-101 Kenei Konarumi-Jutaku No.14-1 Konarumi**
**Narumi-ch Midori-ku Nagoya-shi Aichi-ken (JP)**

**Taira, Hiroshi**
**No. 3-2, Higashino-cho 10-chome**
**Kasugai-shi Aichi-ken (JP)**

**Hayakawa, Kiyoharu No.268, Aza-ryutou**
**Oaza-Sakogishinden Yatomi-cho**
**Ama-gun Aichi-ken (JP)**

**Izaki, Takeshi No.601, Ninomiya-Bld.**
**No.3-21, Yobitsugi 1-chome Minami-ku**
**Nagoya-shi Aichi-ken (JP)**

**Hisada, Hidenori**
**No.5-31, Ano-cho**
**Tokoname-shi Aichi-ken (JP)**

(74) Representative: **Senior, Alan Murray et al**
**J.A. KEMP & CO 14 South Square Gray's Inn**
**London WC1R 5EU (GB)**

(54) **Image recording apparatus.**

(57) An image recording apparatus for recording an image corresponding to an original on a continuous image recording medium such as a photosensitive microcapsule sheet. The apparatus comprises exposure means for exposing the recording medium to light in an exposure zone to form a latent image on the recording medium, developing means for developing the latent image into a visible image, first feeding means disposed downstream of the exposure zone for positively feeding the recording medium, and second feeding means disposed upstream of the exposure zone, the second feeding means being idly rotatable by the recording medium while the recording medium is being fed by the first feeding means. While the recording medium is being fed along the sheet path, it is exposed to light focused by exposure means. During image exposure, the recording medium is held flatwise against an exposure table to allow accurate formation of the image thereon. To keep the recording medium flatwise against the exposure table, the recording medium is tensioned near the exposure table.

*FIG. 1*

Description

# IMAGE RECORDING APPARATUS

## BACKGROUND OF THE INVENTION

The present invention relates to an image recording apparatus, for example an image recording apparatus employing a continuous photosensitive recording medium such as a photosensitive microcapsule sheet.

A photosensitive recording medium as a recording medium can be used in an image recording apparatus such as a copying machine. The image recording apparatus has been designed in such a manner that a photosensitive recording medium is exposed to light which is reflected from or transmitted through an original, and then the light-exposed photosensitive recording medium is developed to form an image corresponding to an original by the developing unit. Such a continuous recording medium is fed across an exposure zone in the apparatus by feed rollers placed upstream and downstream of the exposure zone. Due to speed irregularities of the feed rollers, and slippage of the recording medium, however, the recording medium tends to be wrinkled in the exposure zone while the recording medium is being exposed. When this happens, an image formed on the recording medium is distorted. To solve this problem, the accuracy of the outer peripheral surfaces of the feed rollers must be increased, and the rotational speeds of these feed rollers must be accurately be controlled.

An image recording apparatus of the type described above generally includes an exposure unit and a pressure developing unit. A continuous recording medium is exposed to the light in the exposure unit to form a latent image, and the exposed recording medium is developed in the pressure developing unit at the same time. The speeds at which the continuous recording medium is fed through the exposure unit and the pressure developing unit, respectively, are slightly different from each other. To absorb such a speed difference, the recording medium is gripped by a pair of grip rollers upstream or downstream of the exposure zone, and tensioned by a tension roller so that the recording medium is prevented from sagging.

However, since the grip rollers have different surface hardnesses, different diameters along their axes, and the recording medium is subject to different tensions, the recording medium is apt to get wrinkled, and images formed thereon are distorted.

Certain image recording apparatus have a means for automatically guiding a recording medium toward an exposure zone, the means comprising a number of feed rollers arranged along a sheet path. These feed rollers are rotated to draw the leading end of the recording medium from a cartridge, guide the recording medium across an exposure plate, and wind the recording medium around a takeup reel.

When the feed rollers are uniformly rotated during exposure of the recording medium, the speed of feed by the feed roller immediately upstream of the exposure plate tends to be lower than the speed of feed by the feed roller immediately downstream of the exposure plate because of disturbances and small mechanical errors of power transmission systems. Such a speed difference causes the recording medium to sag at the exposure zone, and no accurate image can be formed on the recording medium.

The above drawback can be eliminated by connecting the upstream feed roller to its power transmission mechanism through an electromagnetic clutch. When the recording medium is guided to the exposure table, the electromagnetic clutch is connected to drive the upstream feed roller. When the recording medium is exposed, the electromagnetic clutch is disconnected to allow the upstream feed roller to be rotated by the recording medium.

The electromagnetic clutch is however required to be selectively turned on and off by a control circuit. The electromagnetic clutch is also expensive.

There are also employed different drive systems for feeding the recording medium through the exposure unit and the pressure developing unit, respectively. A dancer or tension roller is positioned in the region between the drive systems for removing a sag or tension from the recording medium due to a difference in speed between the drive systems. If one of the drive systems fails, however, the recording medium may be cut off or wound around one of the feed rollers, or a developer sheet to be used in combination with the recording medium may be jammed.

Advantages which are or can be,provided by the invention, or preferred aspects thereof, are provision of an image recording apparatus including means for tensioning a recording medium thereby to prevent the continuous recording medium from being wrinkled while it is exposed ;
provision of
an image recording apparatus including means for keeping a recording medium flatwise in an exposure zone so that an image can accurately be formed on the continuous recording medium ;
provision of
an image recording apparatus which can remove wrinkles from a recording medium without employing any expensive electromagnetic clutch and control circuit, and hence is relatively inexpensive to manufacture ;
provision of
an image recording apparatus which has a fault detector for detecting an excessive sag in a recording medium to automatically stop operation of the image recording apparatus.

According to one aspect of the present invention, there is provided an image recording apparatus for recording an image corresponding to an original the apparatus comprising: exposure means for exposing a recording medium to light in an exposure zone to form a latent image on the recording medium; developing means for developing the latent image into a visible image; first feeding means disposed downstream of the exposure zone for positively feeding the recording medium; and second feeding means disposed upstream of the exposure zone, the second feeding means being idly rotatable by the recording medium while the recording medium is being fed by the first feeding means. With this structure, the recording medium is tensioned in the exposing zone, and wrinkles can be removed from the recording medium. The image of the original on the original support stand glass is thus accurately formed as a latent image on the recording medium.

According to another aspect of the present invention, there is provided an image recording apparatus for recording an image corresponding to an original

the apparatus comprising: exposure means for exposing a recording medium to light in an exposure zone to form a latent image on the recording medium; developing means for developing the latent image into a visible image; first drive means for feeding the recording medium upstream of the exposure zone; second drive means for feeding the recording medium downstream of the exposure zone; speed absorbing means disposed between the first and second drive means for absorbing a difference in speed between the first and second drive means; and fault detector means for detecting when the speed absorbing means fails to fully absorb the difference in speed between the first and second drive means. Accordingly, when any one of the drive means and their associated power transmission mechanisms malfunctions, the entire drive system of the copying machine is automatically inactivated, thereby preventing unwanted trouble or damage to the copying machine.

The above and other objects, features and advantages of the present invention will become more apparent from the following description when taken in conjunction with the accompanying drawings in which preferred embodiments of the present invention are shown by way of illustrative example.

## BRIEF DESCRIPTION OF THE DRAWINGS

Fig. 1 is a schematic vertical cross-sectional view of an image forming apparatus according to the present invention;

Fig. 2 is an enlarged perspective view of a feed system near an exposure plate in the image recording apparatus shown in Fig. 1;

Fig. 3 is a block diagram of a drive system in the image recording apparatus of Fig. 1;

Fig. 4 is an enlarged schematic side elevational view of a feed system in the image recording apparatus of Fig. 1;

Fig. 5 and 6 are enlarged schematic side elevational views showing feed systems according to other embodiment of the present invention;

Fig. 7 is an elevational view, partly in cross section, of a guide roller according to another embodiment of the present invention; and

Fig. 8 is a schematic elevational view of a feed system with an automatic fault detector according to still another embodiment of the present invention.

## DETAILED DESCRIPTION OF THE PREFERRED EMBODIMENTS

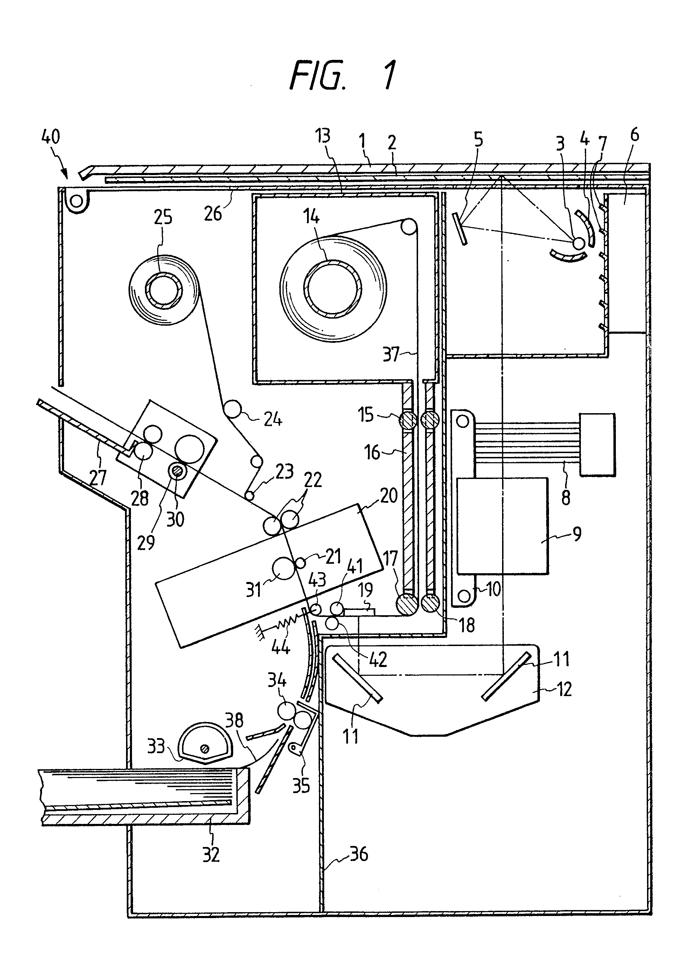

An embodiment of the invention will be described below with reference to Figs. 1 through 3.

Fig. 1 schematically shows a copying machine capable of performing a full-color copying. This copying machine employs the transfer type image recording medium (which comprises a microcapsule sheet and a developer sheet) as described in U.S. Patent 4,399,209 and Japanese Patent Application Kokai No. 58-88739.

The photosensitive microcapsule sheet and the color developer sheet will not be described in detail below.

The copying machine, generally designated by the reference numeral 40 in Fig. 1, includes an upper panel assembly having an original support stand glass 2 which is movable back and forth and a stand cover 1 that can be placed over the original support stand glass 2. An original to be copied is put on the original support stand glass 2 which is formed of light transmissive material. The copying machine 40 also has a light source placed in an upper righthand portion thereof below the original support stand glass 2 and comprising a halogen lamp 3 extending in a direction normal to the direction in which the original support stand glass 2 is movable back and forth, and a semicylindrical reflecting mirror 4 disposed in surrounding relation to the halogen lamp 3. The light source emits a linear-line light ray toward the lower surface of the original support stand glass 2.

When the original support stand glass 2 moves, the light emitted from the halogen lamp 3 continuously irradiates the entire surface of the original support stand glass 2 from the lefthand to the righthand end thereof (as viewed in Fig. 1.). The light from the light source passes through the transparent original support stand glass 2, and is then reflected from the original placed on the original support stand glass 2. The stand cover 1 covers the entire upper surface of the original support stand glass 2 so that the light applied to the original support stand glass 2 will not leak out from those areas of the original support stand glass 2 which are not covered by the original.

A flat reflector 5 is positioned on the lefthand side of the light source for applying light emitted from the halogen lamp 3 to the original highly efficiently. The flat reflector 5 reflects those emitted light which are not directed toward the original support stand glass 2 toward the original support stand glass 2.

A fan 6 and louvers 7 for introducing ambient air into the copying machine are disposed on the righthand side of the halogen lamp 3. The air introduced by the fan 6 and the louvers 7 is efficiently applied to the light source and the original support stand glass 2 to cool them. The light reflected from the original on the original support stand glass 2 is directed downwardly and passes through a filter 8 and a lens 9. The filter 8 alters the light transmissive characteristics in accordance with the sensitivity characteristics of a microcapsule sheet 37, to thereby adjust the color tone of a copied output image. The lens 9 is mounted on a lens mounting plate 10 which is finely angularly adjustable with respect to the path of the light through the filter 8 and the lens 9.

The light converged by the lens 9 is directed 180° back by two reflecting mirrors 11, and then focused on the microcapsule sheet 37 held closely against the lower surface of an exposure table 19. The reflecting mirrors 11 are mounted on a mirror mounting plate 12 which is finely positionally adjustable to vary the length of the light path and the focused condition.

The microcapsule sheet 37 is of a continuous elongate length and wound around a cartridge reel 14 which is placed in a removable cartridge 13 positioned below the original support stand glass 2. A leading end portion of the microcapsule sheet 37 extends through many rollers and a pressure developing unit 20 toward a takeup reel 25.

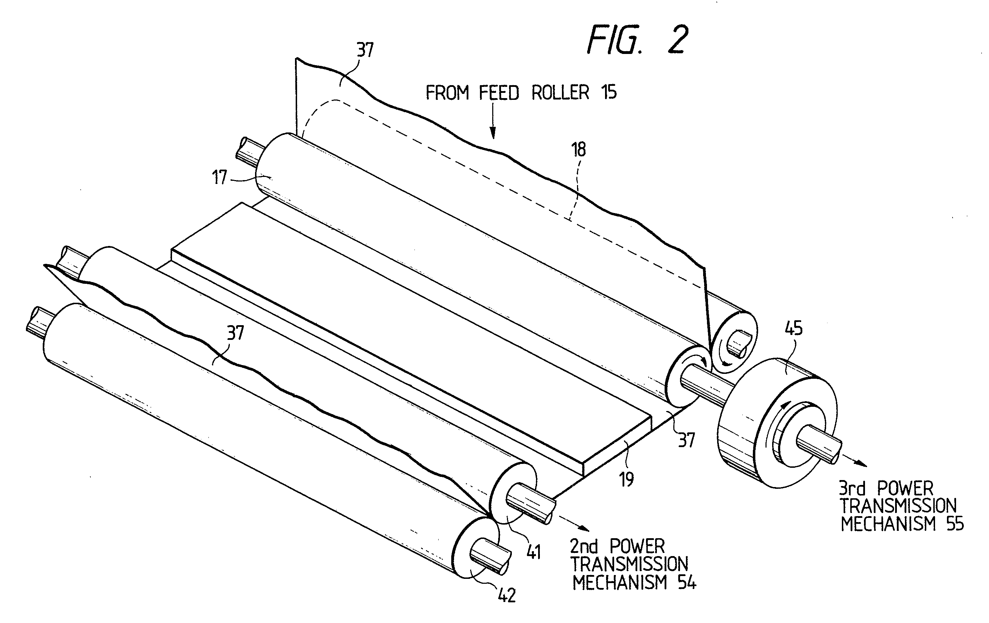

More specifically, the microcapsule sheet 37 drawn out of the cartridge 13 from its lower end is fed and guided by a feed roller 15 and a guide roller 17, and extends beneath the exposure table 19, between a metal roller 41 and a nip roller 42 of rubber, and past a tension or dancer roller 43 into the pressure developing unit 20. When the microcapsule sheet 37 is exposed to the light from the reflecting mirrors 11, the speed of feed by the roller 41 is selected to be higher than the speed of feed by the roller 17. The difference between the rotational speeds of the rollers 17, 41 is achieved by varying the speed reduction ratio between the gears for transmitting drive power to the rollers 17, 41. As shown in Fig. 2, the guide roller 17 is operatively connected by a one-way clutch 45 to a third power transmission mechanism 55 (described later on). The tension roller 43 is biased by a tensioner spring 44 to tension the microcapsule sheet 37 so that slight differences in the speed of travel of the microcapsule sheet 37 across the exposure table 19 and through the pressure developing unit 20 can be absorbed, and any wrinkles can be removed from the microcapsule sheet 37 as it enters the pressure developing unit 20. The microcapsule sheet 37 which has passed through the pressure developing unit 20 is fed by a pair of feed rollers 22, travels past a separator roller 23 and a meander travel control roller 24, and is then wound around the takeup reel 25. The microcapsule sheet 37 discharged from the cartridge 13 remains unexposed by a light-shielding cover 16 before the microcapsule sheet 37 reaches the exposure table 19.

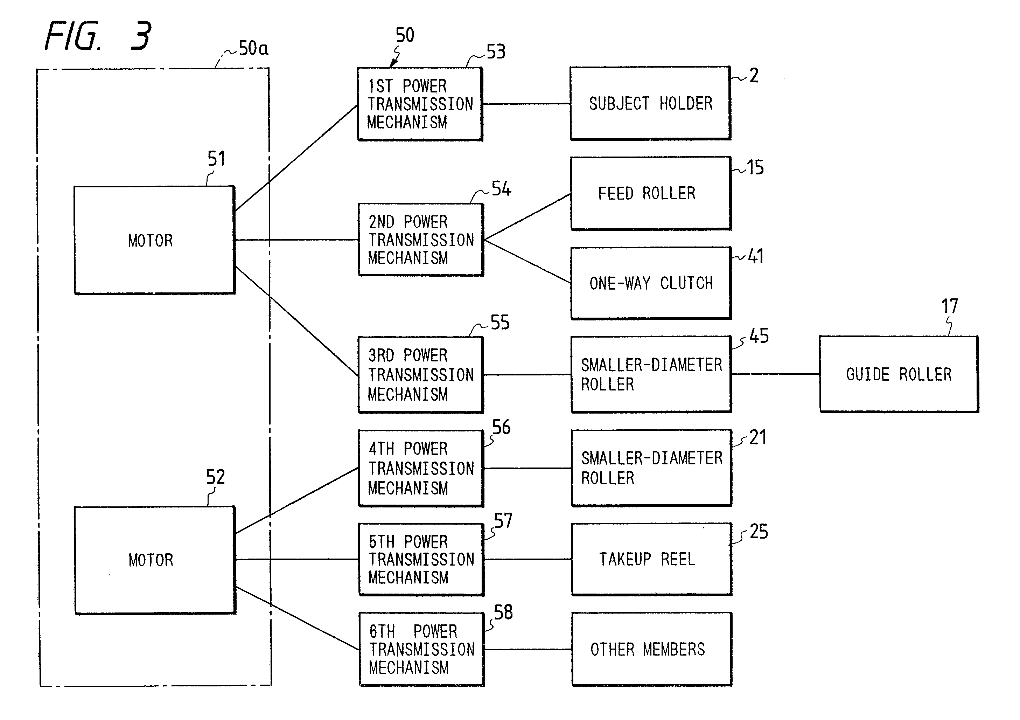

The speed at which the microcapsule sheet 37 is fed is controlled so as to be held at a constant level by means of a motor 51 (Fig. 3) which actuates an exposure unit and a motor 52 which actuates a pressure developing unit. As described above, any slight difference in speed between these motors 51, 52 is absorbed by the tension roller 43 and the tensioner spring 44. The speed of travel of the microcapsule sheet 37 is the same speed as the speed at which the original support stand glass 2 is moved. Therefore, linear latent images having given widths are sequentially formed on the microcapsule sheet which is passing along the exposure table 19.

A developer sheet cassette 32 storing a stack of developer sheets 38 is disposed below the pressure developing unit 20. Immediately above the cassette 32, a sector roller 33 is provided to feed each one of the developer sheet 38 toward the pressure developing unit 20. After the leading end of the developer sheet 38 is positioned by rollers 34 and a resist gate 35, the developer sheet 38 is fed into an inlet slot of the pressure developing unit 20.

The microcapsule sheet 37 and the developer sheet 38 are closely held against each other when they are introduced into the pressure developing unit 20. The pressure developing unit 20 includes a smaller-diameter roller 21 and a backup roller 31. The microcapsule sheet 37 and the developer sheet 38 are superposed and pressed together between the smaller-diameter roller 21 and the backup roller 31. At this time, a microcapsule layer on the microcapsule sheet 37 with the latent image formed thereon and a developer layer on the developer sheet 38 are held against each other. Those microcapsules in the microcapsule layer which are not exposed are ruptured under pressure, and a developed image is transferred onto the developer sheet 38.

The microcapsule sheet 37 and the developer sheet 37 which have left the pressure developing unit 20 are fed by the rollers 22. Then, the microcapsule sheet 37 is separated from the developer sheet 38 by the separation roller 23. The microcapsule sheet 37 is directed upwardly, whereas the developer sheet 38 travels straight ahead into a thermal fixing unit. The thermal fixing unit comprises a hollow heater roller 29 with a heater 30 disposed therein and a feed roller 28. After color development on the developer sheet 38 is promoted and the color image is fixed by the heat fixing unit, the developer sheet 38 is discharged into a tray 27 with the developed image facing up.

The separated microcapsule sheet travels past the meander travel control roller 24 and is then wound around the takeup reel 25.

The exposure unit and the pressure developing unit are substantially optically isolated from each other by a wall 36 in the copying machine 40.

As illustrated in Fig. 3, the motors 51, 52 jointly constitute a motor assembly 50a of a drive system 50 for the copying machine 40. The motor 51 has a rotatable drive shaft coupled to a first power transmission mechanism 53 for moving the original support stand glass 2, a second power transmission mechanism 54 for rotating the metal roller 41 and the feed roller 15, and a third power transmission mechanism 55 for rotating the one-way clutch 45. The motor 52 has a rotatable drive shaft connected to a fourth power transmission mechanism 56 for rotating the smaller-diameter roller 21, a fifth power transmission mechanism 57 for rotating the takeup reel 25, and a sixth power transmission mechanism 58 for driving other members.

The second and third power transmission mechanisms 54, 55 have gears with different speed reduction ratios such that the feed roller 15 and the metal roller 41 rotate at the same peripheral speed but the guide roller 17 rotates at a peripheral speed lower than that of the rollers 15, 41.

Operation of the copying machine 40 will be described below.

First, the microcapsule sheet 37 is automatically fed from the cartridge 13 to the takeup reel 25 as follows:

The cartridge 13 with the microcapsule sheet 37 therein is loaded in position, and a switch (not shown) is turned on to energize a solenoid (not shown) which moves the feed roller 15 into contact with a leading end of the microcapsule sheet 37 extending out of the outlet slot of the cartridge 13. The feed roller 15 is rotated to draw out the leading end of the microcapsule sheet 37. At this time, the peripheral speed of the feed roller 15 is the same speed as that of the metal roller 41. The leading end of the microcapsule sheet 37 is then gripped by the guide roller 17 and the nip roller 18, and fed thereby at a speed lower than the peripheral speed of the feed roller 15. The leading end of the microcapsule sheet 37 passes immediately below the exposure table 19, and is then gripped by the metal roller 41 and the nip roller 42. The metal roller 41 feeds the microcapsule sheet 37 at the same speed as that of the feed roller 15, i.e., a speed higher than that of the guide roller 17. Since the guide roller 17 is driven by the metal roller 41 and the nip roller 42 through the microcapsule sheet 37, at this time, the guide roller 17 tends to rotate at a speed higher than the speed at which it is rotated through the one-way clutch 45. Accordingly, the one-way clutch 45 is disconnected, and the guide roller 17 and the nip roller 18 are rotated by the microcapsule sheet 37 which is pulled by the metal roller 41 and the nip roller 42. The leading end of the microcapsule sheet 37 passes through the pressure developing unit 20 and is finally wound around the takeup reel 25. Thereafter, the switch referred to above is turned off, and the solenoid is de-energized to release the feed roller 15 from the microcapsule sheet 37.

A process of recording an image corresponding to an original on the developer sheet will be described below.

The stand cover 1 is lifted up, and an original to be copied is placed on the original support stand glass 2 in Fig. 1. Then, a start button (not shown) is depressed. The original support stand glass 2 is moved to the right (Fig. 1) until the lefthand end of the original support stand glass 2 is directly above the light source. Then, the halogen lamp 3 is turned on, and the original support stand glass 2 is moved to the left. A light emitted from the halogen lamp 3 is reflected by the original on the original support stand glass 2, then passes through the filter 8 and the lens 9, and is also reflected by the two reflecting mirrors 11. Thereafter, the light is focused on the microcapsule sheet 37 positioned underneath the exposure table 19. At this time, the microcapsule sheet 37 is nipped by the nip roller 42 pressed against the metal roller 41, and moved by the metal roller 41 to the left beneath the exposure table 19 at the same speed as the speed of movement of the original support stand glass 2. Since there is a difference in speed between the metal roller 41 and the guide roller 17, at this time, the one-way clutch 45 for driving the guide roller 17 is disconnected, and the guide roller 17 is rotated as an idler roller by the microcapsule sheet 37, i.e., at the speed of rotation of the metal roller 41. Therefore, the microcapsule sheet 37 is tensioned, and any wrinkles are removed from the microcapsule sheet 37 on the exposure table 19. The image of the original on the original support stand glass 2 is thus accurately formed as a latent image on the microcapsule sheet 37.

As the original support stand glass 2 moves to the left, a developer sheet 38 is taken out of the cassette 32 by the sector roller 33 and superposed on the exposed area of the microcapsule sheet 37 in the pressure developing unit 20. In the pressure developing unit 20, the latent image on the microcapsule sheet 37 is developed and transferred to the developer sheet 38.

Thereafter, the image on the developer sheet 38 is thermally fixed by the thermal fixing unit, and then the developer sheet 38 is discharged into the tray 27. The microcapsule sheet 37 which has left the pressure developing unit 20 is then wound around the takeup reel 25. When the righthand end of the original support stand glass 2 reaches the position directly above the light source, the copying of the original is completed, and the halogen lamp 3 is de-energized.

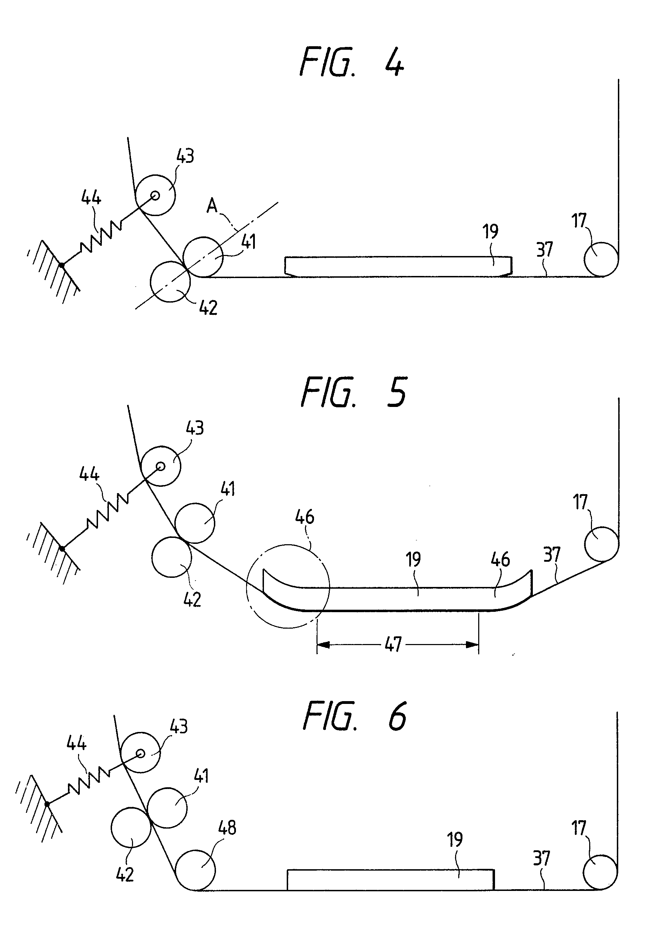

As shown in Fig. 4, a plane A including the axes of the metal and nip rollers 41, 42 is inclined at an angle to the direction in which the microcapsule sheet 37 is fed along the exposure table 19. Therefore, the microcapsule sheet 37 is held in contact with the metal roller 41 along the contour of the peripheral surface of the metal roller 41 with a great length. Since the microcapsule sheet 37 is fed by the metal roller 41 while it is held in arcuate surface-to-surface contact with the peripheral surface of the roller 41, the microcapsule sheet 37 is uniformly pulled by the roller 41 and hence remains flat beneath the exposure table 19. Consequently, any latent images formed on the microcapsule sheet 37 held flatwise against the exposure table 19 are not distorted or blurred.

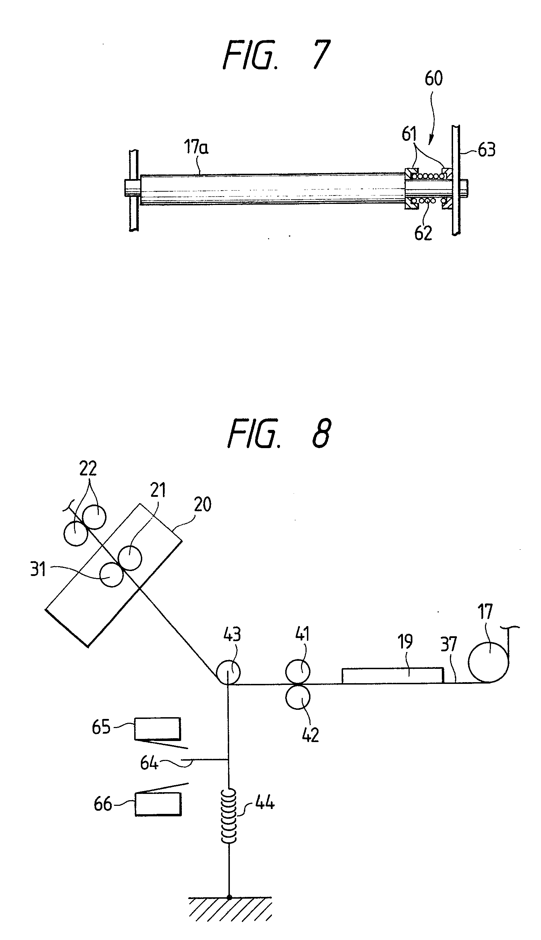

Fig. 5 and 6 illustrate different feed systems according to other embodiments of the present invention, which can be incorporated in the image recording apparatus. Those parts shown in Figs. 5 and 6 which are identical to those of Fig. 1 are denoted by identical reference numerals.

In Fig. 5, an exposure table 19 has a pair of upwardly curved ends 46 on each side of an exposure zone 47. The microcapsule sheet 37 is guided to travel along the lower surface of each of the upwardly curved ends 46, so that the microcapsule sheet 37 is kept flatwise against the exposure table 19 especially in the exposure zone 47.

In Fig. 6, an idler roller 48 is placed between the rollers 41, 42 and the exposure table 19, and positioned such that the microcapsule sheet 37 is held in arcuate surface-to-surface contact with the peripheral surface of the idler roller 48. The roller 48 is rotated by the microcapsule sheet 37 as it is fed by the rollers 41, 42.

Fig. 7 illustrates a guide roller according to another embodiment of the present invention. The guide roller, denoted at 17a, comprises an idler roller and is combined with a slip mechanism 60 including a pair of clutch plates 61 on one end of the guide roller 17a and a spring 62 disposed between the clutch plates 61. The clutch plates 61 are biased by the spring 62 against the end of the guide roller 17a and a frame 63, respectively. When the microcapsule sheet is fed, it rotates the guide roller 17a. At this time, the guide roller 17a is subjected to a load due to frictional forces between the guide roller 17a, the clutch plates 61, and the frame 63, the load acting on the guide roller 17a in a direction opposite to the direction of rotation thereof. The load should preferably be slightly smaller than the force with which the guide roller 17a is rotated by the microcapsule sheet 37.

Fig. 8 shows a feed system combined with an automatic fault detector according to still another embodiment of the present invention. In this embodiment, the tensioner spring 44 coupled to the tension roller 43 has a detector rod 64 projecting laterally therefrom. Upper and lower position detector switches 65, 66 are positioned in vertically spaced relation to each other with the detector rod 64 extending therebetween. If the motor 52 or one of the power transmission mechanisms associated therewith (Fig. 3) fails during operation of the copying machine 40, then the feeding movement of the microcapsule sheet 37 from the tension roller 43 to the takeup reel 25 is stopped. The microcapsule sheet 37 is however continuously fed from the cartridge 13 to the tension roller 43 because the motor 51 and its associated power transmission mechanisms are operated. Therefore, the microcapsule sheet 37 sags near the tension roller 43. The tension roller 43 is then lowered under the bias of the tensioner spring 44, and the detector rod 64 contacts the lower position detector switch 66, which is then turned on. When the lower position detector switch 66 is turned on, the motors 51, 52 are de-energized. Conversely, if the motor 51 or one of its associated power transmission mechanism fails, then the microcapsule sheet 37 from the cartridge 13 to the tension roller 43 is stopped, but the microcapsule sheet 37 is continuously pulled by the rollers 21, 22 and hence pulls the tension roller 43 upwardly. The detector rod 64 is then moved toward the upper position detector switch 65 and turns it on, whereupon the motors 51, 52 are also de-energized.

Accordingly, when any one of the motors 51, 52 and their associated power transmission mechanisms malfunctions, the entire drive system of the copying machine is automatically inactivated, thereby preventing unwanted trouble or damage to the copying machine.

The drive system may be arranged such that after one of the position detector switches 65, 66 has continuously been contacted by the detector rod 64 for a certain period of time, the drive system is automatically stopped. The position detector switches 65, 66 are not limited to mechanical switches, but may be optical or magnetic sensors.

Although certain preferred embodiments have been shown and described, it should be understood that many changes and modifications may be made therein without departing from the scope of the appended claims.

## Claims

1. An image recording apparatus for recording an image corresponding to an original said apparatus including:
exposure means for exposing a recording medium to light in an exposure zone to form a latent image on the recording medium;
developing means for developing the latent image into a visible image;
first feeding means disposed downstream of said exposure zone for positively feeding the recording medium; and
second feeding means disposed upstream of said exposure zone, said second feeding means being idly rotatable by the recording medium during forwarding of the recording medium by said first feeding means.

2. An image recording apparatus according to claim 1, wherein said second feeding means comprises an idler roller.

3. An image recording apparatus according to claim 1, further comprising a one-way clutch interposed between a driven shaft supporting said second feeding means and a drive shaft coupled to a driving source, said one-way clutch being disengageable to allow said second feeding means to rotate idly when the rotation speed of said driven shaft is higher than that of said drive shaft due to feeding of the recording medium.

4. An image recording apparatus according to claim 2, wherein said second feeding means includes a mechanism for producing resisting force in a direction opposite to feeding direction of the recording medium, said resisting force being smaller than the force with which the recording medium is fed by said first feeding means.

5. An image recording apparatus according to claim 4, wherein said mechanism comprises a plate and a spring for normally urging said plate against one end of said second feeding means.

6. An image recording apparatus according to any preceding claim wherein said first feeding means comprises a pair of rollers, said pair of rollers being positioned so as to grip the recording medium therebetween and having respective axes lying in a plane which is inclined with respect to a plane in which the recording medium is fed in said exposure zone.

7. An image recording apparatus according to any preceding claim wherein said exposure means includes an exposure table disposed in said exposure zone and against which the recording medium is held, said exposure table including at least one curved portion along which the recording medium passes.

8. An image recording apparatus according to any preceding claim further comprising a idler roller disposed between said first feeding means and said exposure means and to be held against the recording medium.

9. An image recording apparatus according to any preceding claim including speed absorbing means located between feed means for the receiving medium which are respectively located up and down stream of the exposure zone.

10. An image recording apparatus according to any preceding claim including a fault detector effective to detect faulty feed of the recording medium.

11. An image recording apparatus for recording an image corresponding to an original said apparatus including:

exposure means for exposing a recording medium to light in an exposure zone to form a latent image on the recording medium;

developing means for developing the latent image into a visible image;

first drive means for feeding the recording medium upstream of said exposure zone;

second drive means for feeding the recording medium downstream of said exposure zone;

speed absorbing means disposed between said first and second drive means for absorbing a difference in speed between said first and second drive means; and

fault detector means for detecting when said speed absorbing means fails to fully absorb the difference in speed between said first and second drive means.

12. An image recording apparatus according to claim 9 or 11 wherein said speed absorbing means comprises a tension roller held against the recording medium and a tensioner for normally biasing said tension roller in a direction to tension said recording medium.

13. An image recording apparatus according to claim 9, 10, 11 or 12 wherein said fault detector comprises a detector rod of which the position is responsive to tension in the recording medium and a pair of position detector switches disposed on each side of said detector rod and triggerable by the detector rod.

# FIG. 1

FIG. 2

FROM FEED ROLLER 15

3rd POWER TRANSMISSION MECHANISM 55

2nd POWER TRANSMISSION MECHANISM 54

# FIG. 3

MOTOR (51)
- 1ST POWER TRANSMISSION MECHANISM (50) (53) → SUBJECT HOLDER (2)
- 2ND POWER TRANSMISSION MECHANISM (54) → FEED ROLLER (15), ONE-WAY CLUTCH (41)
- 3RD POWER TRANSMISSION MECHANISM (55) → SMALLER-DIAMETER ROLLER (45) → GUIDE ROLLER (17)

MOTOR (52)
- 4TH POWER TRANSMISSION MECHANISM (56) → SMALLER-DIAMETER ROLLER (21)
- 5TH POWER TRANSMISSION MECHANISM (57) → TAKEUP REEL (25)
- 6TH POWER TRANSMISSION MECHANISM (58) → OTHER MEMBERS

EP 0 350 310 A2

## FIG. 4

## FIG. 5

## FIG. 6

EP 0 350 310 A2

FIG. 7

FIG. 8